# EUROPEAN PATENT APPLICATION

(11) **EP 3 862 160 A1**
(43) Date of publication of application: **11.08.2021**
(21) Application number: 19869353.3
(22) Date of filing: 01.10.2019
(51) Int. Cl.: B29C 33/68, C08J 5/18, H01L 21/60, H01L 21/603

(54) **HEAT-RESISTANT RELEASE SHEET AND THERMOCOMPRESSION BONDING METHOD**

(30) Priority: 04.10.2018 JP 2018189068
(71) Applicant: NITTO DENKO CORPORATION, Ibaraki-shi Osaka 567-8680 (JP)
(72) Inventor: AKIBA, Kurato, Ibaraki-shi, Osaka 567-8680 (JP)
(74) Representative: Müller-Boré & Partner Patentanwälte PartG mbB
(86) International application number: PCT/JP2019/038802
(87) International publication number: WO 2020/071386

(57) **Abstract**

The heat-resistant release sheet of the present disclosure is a sheet including a sheet made of polytetrafluoroethylene (PTFE) or a modified PTFE, wherein the sheet is disposed between a compression bonding target and a thermocompression head at the time of thermocompression-bonding the compression bonding target by the thermocompression head to prevent fixation between the compression bonding target and the thermocompression head, and the content of a tetrafluoroethylene (TFE) unit in the modified PTFE is 99 mass% or more. The heat-resistant release sheet of the present disclosure can more reliably meet a demand for a shorter time (work time) required for thermocompression bonding.

## Description

### TECHNICAL FIELD

The present invention relates to a heat-resistant release sheet and a thermocompression bonding method using the same.

### BACKGROUND ART

Thermocompression bonding is used for manufacturing and flip chip mounting of semiconductor chips using an underfill such as a non-conductive film (NCF) and a non-conductive paste (NCP) and for manufacturing of printed circuit boards (PCBs). Thermocompression bonding is also used, for example, for bonding of an electronic part to a PCB by using an anisotropic conductive film (ACF). A thermocompression head, which is a heat source as well as a pressure source, is generally used to thermocompression-bond a compression bonding target. In order to prevent fixation between the compression bonding target and the thermocompression head at the time of thermocompression bonding, a heat-resistant release sheet is commonly disposed between the compression bonding target and the thermocompression head.

In Patent Literature 1 is disclosed, though not a heat-resistant release sheet itself, a polyimide film disposed and used between a compression bonding target and a thermocompression head.

### CITATION LIST

### Patent Literature

Patent Literature 1: JP 2014-91763 A

### SUMMARY OF INVENTION

### Technical Problem

Polyimide is known as a resin having high heat resistance. Inclusion of a polyimide film in a heat-resistant release sheet can increase the thermocompression bonding temperature, and is thus expected to improve manufacturing efficiency and mounting efficiency of semiconductor chips. However, the time (work time) required for thermocompression bonding needs to be shorter for further improvement of the above efficiencies. A study by the present inventors has revealed that it is difficult to fully meet the demand for a shorter work time when a polyimide film is included in a heat-resistant release sheet.

The present invention is intended to provide a heat-resistant release sheet that can also meet the demand for a shorter work time more reliably.

### Solution to Problem

The present invention provides a heat-resistant release sheet including a sheet made of polytetrafluoroethylene (hereinafter referred to as "PTFE") or a modified PTFE, wherein
the heat-resistant release sheet is disposed between a compression bonding target and a thermocompression head at the time of thermocompression-bonding the compression bonding target by the thermocompression head to prevent fixation between the compression bonding target and the thermocompression head, and
the content of a tetrafluoroethylene (hereinafter referred to as "TFE") unit in the modified PTFE is 99 mass% or more.

In another aspect, the present invention provides a method for thermocompression-bonding a compression bonding target by a thermocompression head, the method including thermocompression-bonding the compression bonding target by the thermocompression head with a heat-resistant release sheet disposed between the thermocompression head and the compression bonding target, wherein
the heat-resistant release sheet is the above heat-resistant release sheet of the present invention.

### Advantageous Effects of Invention

The PTFE sheet or the modified PTFE sheet included in the heat-resistant release sheet of the present invention has high heat resistance derived from the PTFE or the modified PTFE. Moreover, the PTFE sheet and the modified PTFE sheet have a better ability to conduct heat to a compression bonding target at the time of thermocompression bonding using a thermocompression head than that of a polyimide film. Therefore, the heat-resistant release sheet of the present invention can also meet the demand for a shorter work time more reliably.

### BRIEF DESCRIPTION OF DRAWINGS

FIG. 1 is a cross-sectional view schematically showing an example of the heat-resistant release sheet of the present invention.
FIG. 2 is a schematic diagram illustrating an example of a thermocompression bonding method using the heat-resistant release sheet of the present invention.
FIG. 3 shows a schematic diagram illustrating a method for evaluating heat-resistant release sheets of Examples and Comparative Examples for the ability to conduct heat to a compression bonding target at the time of thermocompression bonding using a thermocompression head.

### DESCRIPTION OF EMBODIMENTS

Hereinafter, embodiments of the present invention will be described with reference to the drawings.

### [Heat-resistant release sheet]

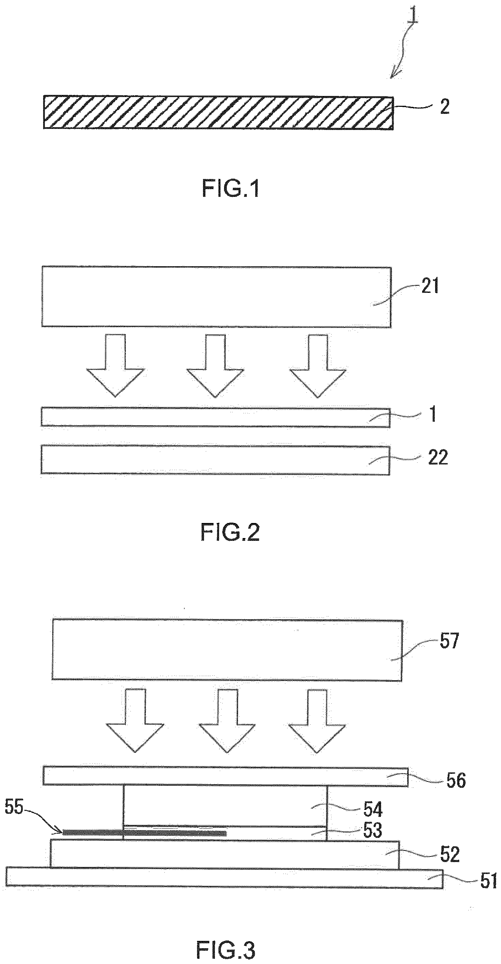

FIG. 1 shows an example of the heat-resistant release sheet of the present invention. A heat-resistant release sheet 1 shown in FIG. 1 is composed of a PTFE sheet 2. The heat-resistant release sheet 1 of FIG. 1 has a single-layer structure consisting of the PTFE sheet 2. The heat-resistant release sheet 1 has high heat resistance and high releasability derived from PTFE included in the sheet 2.

In an industrial thermocompression bonding process, generally, a thermocompression head is positioned over a path for conveying compression bonding targets and thermocompression-bonds the compression bonding targets one after another that are being conveyed along the path. In this thermocompression bonding process, a strip-shaped heat-resistant release sheet is, in some cases, fed between the thermocompression head and the compression bonding target(s) by conveyance. In such cases, it is common that a new heat-resistant release sheet is fed for each thermocompression bonding. In other words, a heat-resistant release sheet is heated from ordinary temperature to a thermocompression bonding temperature for each thermocompression bonding to conduct necessary heat to a compression bonding target. Therefore, a slight difference in heat conductivity between heat-resistant release sheets greatly affects the work time. This effect becomes greater as the thermocompression bonding temperature increases. However, the heat-resistant release sheet 1 including the PTFE sheet 2 has an excellent ability to conduct heat to a compression bonding target at the time of thermocompression bonding using a thermocompression head. Therefore, the heat-resistant release sheet 1 can also meet a demand for a shorter work time more reliably as well as a demand for an increase in thermocompression bonding temperature.

The PTFE included in the PTFE sheet 2 preferably has at least one property selected from the following properties (1) to (3), more preferably at least two of the properties, and even more preferably all of the properties.

Property (1): Heat of crystal melting (hereinafter simply referred to as "heat of melting") evaluated by differential scanning calorimetry (hereinafter referred to as "DSC") at a temperature rise rate of 10°C/min is 25.0 J/g or more. The heat of melting may be 27.0 J/g or more, 28.0 J/g or more, 29.0 J/g or more, or even 30.0 J/g or more. The upper limit of the heat of melting is, for example, 82.0 J/g or less and may be 70.0 J/g or less. When the PTFE has the property (1), the heat-resistant release sheet 1 can have a further improved heat resistance while maintaining a high heat conductivity. The heat of melting of the PTFE can be determined from the peak area of an "endothermic peak attributed to crystal melting of the PTFE," the endothermic peak being measured by using a DSC apparatus to increase the temperature of the PTFE at a constant temperature rise rate. The temperature of the PTFE is increased for the evaluation of the heat of melting, for example, from room temperature to 370°C. The PTFE included in the PTFE sheet 2 is preferably PTFE having been sintered, and, in that case, the endothermic peak attributed to crystal melting commonly appears in the temperature range of 250 to 340°C.

Property (2): The crystallinity (degree of crystallinity) is 33.0% or more. The crystallinity may be 34.0% or more, 35.0% or more, or even 36.0% or more. The upper limit of the crystallinity is, for example, 100.0% or less and may be 85.4% or less. When the PTFE has the property (2), the heat-resistant release sheet 1 can have a further improved heat resistance while maintaining a high heat conductivity. The crystallinity of the PTFE can be determined by dividing a measurement value of the above heat of melting by a theoretical value of the heat of crystal melting that a perfect crystal of the PTFE is supposed to have. The PTFE included in the PTFE sheet 2 is typically PTFE having been sintered, and, in that case, the above theoretical value is 82.0 J/g.

Property (3): The peak temperature (hereinafter referred to as "peak temperature") of the above "endothermic peak attributed to crystal melting" is 325.0°C or higher. The peak temperature may be 326.0°C or higher or even 327.0°C or higher. The upper limit of the peak temperature is, for example, 350.0°C or less. When the PTFE has the property (3), the heat-resistant release sheet 1 can have a further improved heat resistance while maintaining a high heat conductivity.

The heat of melting, the crystallinity, and the peak temperature of the PTFE vary, for example, depending on the molecular weight, the molecular weight distribution, the thermal history including sintering, the polymerization method, and the polymerization history of the PTFE.

The PTFE sheet 2 has a thickness of, for example, 1 to 50 pm, and may have a thickness of 5 to 40 pm, 10 to 35 pm, 20 to 35 µm, or even 25 to 35 µm.

The PTFE sheet 2 is preferably a sintered PTFE sheet including PTFE having been sintered. In the present specification, sintering of PTFE means heating PTFE obtained by polymerization to a temperature equal to or higher than its melting point (327°C), for example, to 340 to 380°C.

The PTFE sheet 2 is preferably a non-porous layer. Including the PTFE having high liquid repellency (water repellency and oil repellency), the PTFE sheet 2 may be an impermeable layer that allows no fluid, such as water, to permeate therethrough in the thickness direction. Including the PTFE having high insulating properties, the PTFE sheet 2 may be an insulating layer (a nonconductive layer).

The PTFE sheet 2 is in the shape of, for example, a polygon such as a square or a rectangle, a circle, an oval, or a strip. The polygon may have a rounded corner. The shape of the PTFE sheet 2 is, however, not limited to these examples.

The PTFE sheet 2 may be a modified PTFE sheet. The modified PTFE sheet can have any combination of the various properties mentioned in the description of the PTFE sheet 2, including the above properties (1) to (3). The modified PTFE is a copolymer of TFE and a modified comonomer. The content of a TFE unit in the copolymer needs to be 99 mass% or more so that the copolymer can be classified as the modified PTFE. The modified PTFE is, for example, a copolymer of TFE and at least one modified comonomer selected from ethylene, perfluoroalkylvinyl ether, and hexafluoropropylene.

The heat of melting, the crystallinity, and the peak temperature of the modified PTFE vary, for example, depending on the molecular weight, the molecular weight distribution, the thermal history including sintering, the polymerization method, and the polymerization history of the modified PTFE, and the type and the content of a structural unit which is a component copolymerized with the TFE unit.

The heat-resistant release sheet 1 has a thickness of, for example, 1 to 50 µm, and may have a thickness of 5 to 40 pm, 10 to 35 µm, 20 to 35 µm, or even 25 to 35 µm.

The heat-resistant release sheet 1 has a tensile strength of, for example, 30.0 MPa or more, and may have a tensile strength of 33.0 MPa or more, 34.0 MPa or more, 36.0 MPa or more, 40.0 MPa or more, 45.0 MPa or more, 50.0 MPa or more, 55.0 MPa or more, or even 60.0 MPa or more. The upper limit of the tensile strength is, for example, 100 MPa or less. The heat-resistant release sheet 1 having a tensile strength in these ranges, particularly the heat-resistant release sheet 1 having a tensile strength of 50.0 MPa or more, can be more reliably fed between a thermocompression head and a compression bonding target by conveyance.

The heat-resistant release sheet 1 has a maximum tensile elongation of, for example, 380% or less, and may have a maximum tensile elongation of 360% or less, 340% or less, 320% or less, 300% or less, 250% or less, 200% or less, 150% or less, or even 130% or less. The lower limit of the maximum tensile elongation is, for example, 30% or more. By virtue of the heat-resistant release sheet 1 having a maximum tensile elongation in these ranges, particularly the heat-resistant release sheet 1 having a maximum tensile elongation of 150% or less, when the heat-resistant release sheet 1 partially adheres to a thermocompression head and/or a compression bonding target at the time of feeding the sheet 1 between the thermocompression head and the compression bonding target by conveyance, the sheet 1 can be prevented from elongating to follow these members. In other words, the releasability of the heat-resistant release sheet 1 from a thermocompression head and/or a compression bonding target can further be improved.

In the heat-resistant release sheet 1, another layer may be disposed on a principal surface of the PTFE sheet 2. It is preferred, however, that no other layer be disposed on a principal surface of the PTFE sheet 2, because, in that case, the heat-resistant release sheet 1 can meet the demand for a shorter work time more reliably. That is, the heat-resistant release sheet 1 preferably has a single-layer structure consisting of the PTFE sheet 2.

The heat-resistant release sheet 1 is in the shape of, for example, a polygon such as a square or a rectangle, a circle, an oval, or a strip. The polygon may have a rounded corner. The shape of the heat-resistant release sheet 1 is, however, not limited to these examples. The polygonal-shaped, circular-shaped, or oval-shaped heat-resistant release sheet 1 can be distributed in the form of a sheet, and the strip-shaped heat-resistant release sheet 1 can be distributed in the form of a winding body (roll) formed of the sheet 1 wound around a winding core. The width of the strip-shaped heat-resistant release sheet 1 and that of the winding body formed of the strip-shaped wound heat-resistant release sheet 1 can be set to any values.

### [Method for manufacturing heat-resistant release sheet]

The heat-resistant release sheet 1 can be manufactured, for example, by the following method.

First, a PTFE powder (molding powder) is charged into a mold, and a given pressure is applied to the powder in the mold for a given period of time to preform the powder. The preforming can be performed at ordinary temperature. The internal space of the mold preferably has a columnar shape so that the below-described cutting using a cutting lathe can be performed. In that case, a columnar preform and a columnar PTFE block can be obtained. Next, the resulting preform is taken out of the mold and sintered at a temperature equal to or higher than the melting point (327°C) of PTFE for a given period of time to obtain a PTFE block. Subsequently, the obtained PTFE block is cut to a given thickness to obtain the PTFE sheet 2 that is a cut sheet (skived sheet). The obtained PTFE sheet 2 may be directly used as the heat-resistant release sheet 1, or may be used as the heat-resistant release sheet 1, for example, after a given treatment or after another layer is laminated thereon. When the PTFE block has a columnar shape, a cutting lathe, which continuously rotates the block and cuts a surface thereof, can be used and the PTFE sheet 2 and the heat-resistant release sheet 1 can be efficiently formed. Moreover, by means of a cutting lathe, the thicknesses of the PTFE sheet 2 and the heat-resistant release sheet 1 are relatively easily controlled and the PTFE sheet 2 and the heat-resistant release sheet 1 can be formed in the shape of a strip, too. Furthermore, the modified PTFE sheet can be formed by the above method with the use of a modified PTFE powder instead of the PTFE powder.

The heat-resistant release sheet 1 may be manufactured by the following method.

First, a substrate sheet having a surface to which a PTFE dispersion is to be applied is prepared. The substrate sheet is made of, for example, a resin, a metal, paper, or a composite material thereof. The surface of the substrate sheet to which the PTFE dispersion is to be applied may have been subjected to a separation treatment for easier separation of the PTFE sheet 2 from the substrate sheet. Any of known methods can be employed for the separation treatment. Next, a coating film of the PTFE dispersion is formed on the surface of the substrate sheet. Any of various coaters can be used for the application of the PTFE dispersion. The PTFE dispersion may be applied to the surface of the substrate sheet by immersing the substrate sheet in the PTFE dispersion. Next, a PTFE sheet is formed by drying and sintering the coating film formed of the PTFE dispersion on the surface of the substrate sheet. Then, the formed PTFE sheet is separated from the substrate sheet to obtain the PTFE sheet 2 that is a cast sheet. The obtained PTFE sheet 2 may be directly used as the heat-resistant release sheet 1, or may be used as the heat-resistant release sheet 1, for example, after a given treatment or after another layer is laminated thereon. The thicknesses of the PTFE sheet 2 and the heat-resistant release sheet 1 formed by this method can be controlled by adjusting the thickness of the PTFE dispersion applied to the substrate sheet and/or the number of times the PTFE dispersion is applied thereto. Additionally, the modified PTFE sheet can be formed by the above method with the use of a modified PTFE dispersion instead of the PTFE dispersion.

The PTFE sheet 2 may be stretched and/or calendered in order to increase the tensile strength of the' heat-resistant release sheet 1 or reduce the maximum tensile elongation of the heat-resistant release sheet 1.

### [Use of heat-resistant release sheet]

As shown in FIG. 2, the heat-resistant release sheet 1 can be used as a heat-resistant release sheet disposed between a thermocompression head 21 and a compression bonding target 22 at the time of thermocompression-bonding the compression bonding target 22 by the thermocompression head 21 to prevent fixation between the thermocompression head 21 and the compression bonding target 22. The heat-resistant release sheet 1 has high releasability. It is possible to prevent fixation (heat fixation) of the heat-resistant release sheet 1 to the thermocompression head 21 and/or the compression bonding target 22, the fixation being caused by heat generated for thermocompression bonding.

The heat-resistant release sheet 1 may be fed and disposed between the thermocompression head 21 and the compression bonding target 22 by conveyance. The heat-resistant release sheet 1 fed and disposed by conveyance is, for example, in the shape of a strip.

Examples of the compression bonding target 22 include a semiconductor chip, a PCB, and an electronic part. The heat-resistant release sheet 1 can be used, for example, for manufacturing and flip chip mounting of semiconductor chips, manufacturing of PCBs, and bonding of electronic parts by thermocompression bonding.

### [Thermocompression bonding method]

The compression bonding target 22 can be thermocompression-bonded using the heat-resistant release sheet 1 of the present invention. The thermocompression bonding method is a method for thermocompression-bonding the compression bonding target 22 by the thermocompression head 21. The thermocompression bonding method includes thermocompression-bonding the compression bonding target 22 by the thermocompression head 21 with the heat-resistant release sheet 1 disposed between the thermocompression head 21 and the compression bonding target 22. The heat-resistant release sheet 1 can be fed and disposed between the thermocompression head 21 and the compression bonding target 22, for example, by conveyance.

### [Method for manufacturing thermocompression bonded article]

A thermocompression bonded article can be manufactured using the heat-resistant release sheet 1 of the present invention. The method for manufacturing the thermocompression bonded article includes a step of thermocompression-bonding the compression bonding target 22 using the thermocompression head 21 with the heat-resistant release sheet 1 disposed between the thermocompression head 21 and the compression bonding target 22 to obtain a thermocompression bonded article which is a thermocompression bonded body of the compression bonding target 22. Examples of the thermocompression bonded article include a PCB and an electronic parts.

### EXAMPLES

Hereinafter, the present invention is described in more detail with reference to examples. The present invention is not limited to the following examples.

First, the methods for evaluating heat-resistant release sheets produced in examples will be described.

### [Heat of melting, crystallinity, and peak temperature]

For heat-resistant release sheets of Examples 1 to 6 having a single-layer structure consisting of a PTFE sheet or a modified PTFE sheet and a heat-resistant release sheet of Comparative Example 1 having a single-layer structure consisting of a tetrafluoroethylene-perfluoroalkoxyethylene copolymer (hereinafter referred to as "PFA") sheet, the heat of melting of a fluorine resin (PTFE, a modified PTFE, or PFA) forming each sheet was evaluated by the following methods.

From each heat-resistant release sheet to be evaluated was obtained 10 mg of a sample of the fluorine resin forming the sheet. Next, the obtained sample was set in a DSC apparatus (DSC 200 F3 manufactured by NETZSCH Japan K.K.), and a DSC curve was obtained by increasing the temperature from room temperature to 400°C at a temperature rise rate of 10°C/min. An endothermic peak appearing in the temperature range of 250 to 340°C in the obtained DSC curve and attributed to crystal melting of the fluorine resin was analyzed to determine the peak temperature and the heat of melting of the fluorine resin. Additionally, the crystallinities of the PTFEs and the modified PTFE (Examples 1 to 6) and the crystallinity of the PFA (Comparative Example 1) were each determined by dividing the heat of melting determined as above by the theoretical value (82.0 J/g) of the heat of crystal melting of sintered PTFE.

### [Tensile strength and maximum tensile elongation]

The tensile strength (tensile strength at break) and the maximum tensile elongation were determined by a tensile test using a tensile testing machine (AG-I manufactured by Shimadzu Corporation). The tensile direction was the longitudinal direction (MD direction) of the heat-resistant release sheets. Specimens had the shape of a No. 1 dumbbell defined in JIS K 6251: 1993. The measurement conditions were such that the measurement temperature was 25°C, the test length of the dumbbell of the specimen was 40 mm, the chuck-to-chuck distance was 70 mm, and the tensile rate was 200 mm/min. The maximum tensile elongation was calculated from the above pre-test (original) test length of the dumbbell and the test length of the dumbbell at break.

### [Releasability at the time of thermocompression bonding]

The releasability at the time of thermocompression bonding was evaluated as follows.

A semiconductor chip (size: 7.3 mm × 7.3 mm; thickness: 725 µm) serving as a simulated compression bonding target was disposed on a stage of a thermocompression bonding apparatus (a flip chip bonder FC3000W manufactured by Toray Engineering Co., Ltd.) equipped with a thermocompression head and the stage. Further, each of the heat-resistant release sheets to be evaluated was cut to a size of 75 mm × 75 mm and disposed on the semiconductor chip. The heat-resistant release sheet was disposed such that the semiconductor chip was located roughly at the center of the heat-resistant release sheet when observed in the direction perpendicular to the mounting surface of the stage. The set temperature of the stage was 120°C. Next, after the thermocompression head was lowered so as to reach a compression pressure of 20 N, the temperature of the head was increased to 300°C and a thermocompression bonding test was performed for a compression time of 10 seconds to evaluate whether heat fixation of the heat-resistant release sheet to the thermocompression head or the semiconductor chip serving as a compression bonding target occurred. The releasability was judged as good (o) when the heat-resistant release sheet was separated from the thermocompression head or the semiconductor chip by itself or by pulling the sheet by hand after the thermocompression bonding test. The releasability was judged as poor (×) when the heat-resistant release sheet was not separated by pulling the sheet by hand after the thermocompression bonding test.

### [Heat conductivity at the time of thermocompression bonding]

The heat conductivity at the time of thermocompression bonding was evaluated as follows. A specific evaluation method will be described with reference to FIG. 3.

Assuming simulated flip chip mounting, a silicon substrate 52 (thickness: 360 µm), an adhesive sheet 53 (EM-350ZT-P manufactured by NITTO DENKO CORPORATION; thickness: 60 µm) assumed to be an NCF, and a semiconductor chip 54 (size: 7.3 mm × 7.3 mm; thickness: 725 µm) were disposed in this order on a stage 51 of a thermocompression bonding apparatus (a flip chip bonder FC3000W manufactured by Toray Engineering Co., Ltd.) equipped with a thermocompression head 57 and the stage 51. A thermocouple 55 for measurement of the highest achieved temperature the adhesive sheet 53 reached in a thermocompression bonding test was inserted in the adhesive sheet 53. The thermocouple 55 was disposed such that a measuring part at its tip was located roughly at the center of the adhesive sheet 53 when observed in the direction perpendicular to the mounting surface of the stage 51. Next, a heat-resistant release sheet 56 to be evaluated was cut to a size of 150 mm × 150 mm and disposed on the semiconductor chip 54. The heat-resistant release sheet 56 was disposed such that the semiconductor chip 54 was located roughly at the center of the heat-resistant release sheet 56 when observed in the direction perpendicular to the mounting surface of the stage 51. The set temperature of the stage 51 was 120°C. Next, after the thermocompression head 57 was lowered so as to reach a compression pressure of 20 N, the temperature of the head was increased to 280°C and a thermocompression bonding test was performed for a compression time of 10 seconds to measure the highest achieved temperature the adhesive sheet 53 reached in the test using the thermocouple 55. The heat conductivity of the heat-resistant release sheet at the time of thermocompression bonding using the thermocompression head was evaluated from the measured highest achieved temperature.

### [Heat resistance]

The heat resistance was evaluated by pressing the tip of a soldering iron set to 280°C, 290°C, or 300°C. Specifically, the tip of a soldering iron set to each of the above temperatures was pressed for 10 seconds against a surface of each heat-resistant release sheet to be evaluated. The heat resistance was judged as good (o) when the surface of the heat-resistant release sheet was not molten by the heat of the soldering iron. The heat resistance was judged as poor (×) when the surface was molten.

### (Example 1)

A PTFE powder (POLYFLON PTFE M-18 manufactured by DAIKIN INDUSTRIES, LTD.) was charged into a cylindrical mold and preformed at a temperature of 23°C and a pressure of 8.5 MPa for a pressure application time of 1 hour. Next, the resulting preform was taken out of the mold and sintered at 370°C for 24 hours to obtain a columnar PTFE block having a height of 300 mm and an outer diameter of 470 mm. Then, the obtained PTFE block was cut using a cutting lathe to produce a 30-µm-thick PTFE sheet, which was employed as a heat-resistant release sheet of Example 1.

### (Example 2)

A 30-µm-thick modified PTFE sheet was produced in the same manner as in Example 1, except that a modified PTFE powder (Dyneon TFM, modified PTFE, TFM 1700 manufactured by 3M Company; content of TFE unit: 99 mass% or more) was used instead of the PTFE powder. The 30-µm-thick modified PTFE sheet was employed as a heat-resistant release sheet of Example 2.

### (Example 3)

To a commercially-available PTFE dispersion (Fluon AD911E manufactured by AGC Inc.) was added a fluorine surfactant (CF₃(CF₂)₇CH₂CH₂-(OCH₂CH₂)ₘOH, where m = 3 to 5) in an amount of 0.67 weight% relative to the PTFE solid content to prepare a PTFE dispersion for formation of a coating film on a substrate sheet. Next, a strip-shaped aluminum foil (manufactured by Mitsubishi Aluminum Co., Ltd.; thickness: 60 µm) serving as a substrate sheet was immersed in the above-prepared PTFE dispersion and was pulled out to form a coating film of the PTFE dispersion on a surface of the substrate sheet. Subsequently, the substrate sheet was heated in a heating furnace set at 100°C to dry the coating film, and was further heated in a heating furnace set at 380°C to sinter the dried film. The immersion of the substrate sheet in the PTFE dispersion and the drying and sintering after the immersion were performed continuously by conveying the substrate sheet by rolls at a speed of 0.7 m/min. Then, immersion in the PTFE dispersion and subsequent drying and sintering were performed again as described above to form a 30-µm-thick PTFE sheet on the substrate sheet. The formed PTFE sheet was separated from the substrate sheet and was employed as a heat-resistant release sheet of Example 3.

### (Example 4)

A PTFE block as produced in Example 1 was cut using a cutting lathe to obtain a 50-pm-thick skived PTFE film. Next, the obtained skived film was calendered using a roll calendering machine equipped with a pair of metal rolls maintained at 170°C to produce a 30-µm-thick PTFE sheet, which was employed as a heat-resistant release sheet of Example 4.

### (Example 5)

A heat-resistant release sheet of Example 5 was obtained in the same manner as in Example 3, except that a PTFE sheet formed on a substrate sheet had a thickness of 5 µm and was separated from the substrate sheet to be employed as a heat-resistant release sheet.

### (Example 6)

A heat-resistant release sheet of Example 6 was obtained in the same manner as in Example 3, except that a PTFE sheet formed on a substrate sheet had a thickness of 10 µm and was separated from the substrate sheet to be employed as a heat-resistant release sheet.

### (Comparative Example 1)

A 25-pm-thick PFA sheet (NEOFLON PFAAF-0025 manufactured by DAIKIN INDUSTRIES, LTD.; content of perfluoroalkoxyethylene unit: 1 mass% or more) was prepared as a heat-resistant release sheet of Comparative Example 1.

### (Comparative Example 2)

A 25-µm-thick polyimide sheet (Kapton 100H manufactured by DU PONT-TORAY CO., LTD.) was prepared as a heat-resistant release sheet of Comparative Example 2.

Table 1 below shows the results of evaluating the properties of the heat-resistant release sheets of Examples and Comparative Examples. The heat conductivity (highest achieved temperature) was unable to be measured for Comparative Example 1 because the heat-resistant release sheet was molten.

**[Table 1]**

| | | Example | | | | | | Comparative Example | |
|---|---|---|---|---|---|---|---|---|---|
| | | 1 | 2 | 3 | 4 | 5 | 6 | 1 | 2 |
| Heat of melting (J/g) | | 36.0 | 36.4 | 31.4 | 33.3 | 30.5 | 30.8 | 24.8 | - |
| Crvstallinitv (%) | | 43.9 | 44.4 | 38.3 | 40.6 | 37.1 | 37.4 | 30.3 | - |
| Peak temperature (°C) | | 331.6 | 328.2 | 327.8 | 331.4 | 328.0 | 327.0 | 302.7 | - |
| Tensile strength (MPa) | | 34.6 | 42.1 | 39.8 | 66.2 | 31.6 | 34.7 | 38.8 | 263 |
| Maximum tensile elongation (%) | | 177 | 278 | 352 | 120 | 320 | 340 | 397 | 31 |
| Releasability (from thermocompression head) | | ○ | ○ | ○ | ○ | ○ | ○ | × | ○ |
| Releasability (from compression bonding target) | | ○ | ○ | ○ | ○ | ○ | ○ | × | ○ |
| Heat conductivity/highest achieved temperature (°C) | | 238 | 236 | 236 | 237 | 248 | 246 | Molten | 230 |
| Heat resistance | 280°C | ○ | ○ | ○ | ○ | ○ | ○ | ○ | ○ |
| | 290°C | ○ | ○ | ○ | ○ | ○ | ○ | × | ○ |
| | 300°C | ○ | ○ | ○ | ○ | ○ | ○ | × | ○ |

| | | | | | | | | | |
|---|---|---|---|---|---|---|---|---|---|
| * The symbol "-" in the table means "unmeasured." | | | | | | | | | |

### INDUSTRIAL APPLICABILITY

The heat-resistant release sheet of the present invention can be used to prevent fixation between a thermocompression head and a compression bonding target by disposing the sheet between the thermocompression head and the compression bonding target at the time of thermocompression-bonding the compression bonding target by the thermocompression head. Thermocompression bonding using the heat-resistant release sheet of the present invention is applicable, for example, to manufacturing and flip chip mounting of semiconductor chips, manufacturing of PCBs, and bonding of electronic parts.

## Claims

1. A heat-resistant release sheet comprising a sheet made of polytetrafluoroethylene (PTFE) or a modified PTFE, wherein
the heat-resistant release sheet is disposed between a compression bonding target and a thermocompression head at the time of thermocompression-bonding the compression bonding target by the thermocompression head to prevent fixation between the compression bonding target and the thermocompression head, and
the content of a tetrafluoroethylene (TFE) unit in the modified PTFE is 99 mass% or more.

2. The heat-resistant release sheet according to claim 1, wherein heat of crystal melting of the PTFE or the modified PTFE evaluated by differential scanning calorimetry (DSC) at a temperature rise rate of 10°C/min is 25.0 J/g or more.

3. The heat-resistant release sheet according to claim 1 or 2, having a thickness of 1 to 50 µm.

4. The heat-resistant release sheet according to any one of claims 1 to 3, having a tensile strength of 30.0 MPa or more.

5. The heat-resistant release sheet according to any one of claims 1 to 4, having a maximum tensile elongation of 380% or less.

6. A method for thermocompression-bonding a compression bonding target by a thermocompression head, the method comprising thermocompression-bonding the compression bonding target by the thermocompression head with a heat-resistant release sheet disposed between the thermocompression head and the compression bonding target, wherein
the heat-resistant release sheet is the heat-resistant release sheet according to any one of claims 1 to 5.
